Europäisches Patentamt

European Patent Office

Office européen des brevets

(11) Veröffentlichungsnummer: **0 279 352**
**A2**

## EUROPÄISCHE PATENTANMELDUNG

(21) Anmeldenummer: 88101987.1

(22) Anmeldetag: 11.02.88

(51) Int. Cl.⁴ **G01R 33/06**

(30) Priorität: 20.02.87 DE 3705403

(43) Veröffentlichungstag der Anmeldung:
24.08.88 Patentblatt 88/34

(84) Benannte Vertragsstaaten:
**BE DE FR GB IT SE**

(71) Anmelder: **Standard Elektrik Lorenz Aktiengesellschaft**
**Lorenzstrasse 10**
**D-7000 Stuttgart 40(DE)**

(72) Erfinder: **Löwel, Helmut**
**Preysingstrasse 6**
**D-8500 Nürnberg(DE)**

(74) Vertreter: **Hösch, Günther, Dipl.-Ing. et al**
**Standard Elektrik Lorenz AG Patent- und**
**Lizenzwesen Postfach 30 09 29**
**D-7000 Stuttgart 30(DE)**

(54) Schaltung zur Verstärkung und Formung eines Wechselspannungssignals.

(57) Bei einer Schaltung zur Verstärkung eines am Teilerpunkt eines wenigstens einen magnetfeldabhängigen Widerstand aufweisenden Spannungsteilers, der über einen Vorwiderstand an eine Versorgungsspannung angeschlossen ist, abgegriffenen Meßsignals mit einem Wechselspannungteil und zur Formung desselben in ein zumindest einer Rechteckform angenähertes Ausgangssignal wird zur Vereinfachung der Schaltung und um mit möglichst wenigen kleinen Bauteilen und Zuleitungen auszukommen, der von der Versorgungsspannung ($U_V$) gelieferte Strom (i) im wesentlichen entsprechend der Änderung des Wechselspannungsanteils ($U_W$) des Meßsignals ($U_M$) durch einen in die Zuleitung der Versorgungsspannung ($U_V$) eingeschalteten und vom Meßsignal ($U_M$) angesteuerten steuerbaren Impedanzwandler (5) verändert.

Fig. 5

# Schaltung zur Verstärkung und Formung eines Wechselspannungssignals

Die vorliegende Erfindung bezieht sich auf eine Schaltung zur Verstärkung und Formung eines Wechselspannungssignals gemäß dem Oberbegriff des Anspruchs 1.

Eine Schaltung und Signalformung einer aus vier magnetfeldabhängigen Widerständen bestehenden Brückenschaltung ist aus der Zeitschrift "Elektronik", Heft 10 vom 17.05.1985, S. 99 bis 101, bekannt. Dort ist auf S. 100 als Signalverstärker ein Operationsverstärker und als Impulsformer ein als Schmitt-Trigger geschalteter Operationsverstärker verwendet. Die Versorgungsspannung wird als konstant vorausgesetzt und eine Temperaturkompensation wird durch einen Widerstand mit positivem Temperaturkoeffizienten über einen weiteren Verstärker sowie über einen zusätzlichen Spannungsteiler vorgenommen. Weiterhin liegen in den Zuleitungen zum Signalverstärker je ein Widerstand, um eine störende Temperaturabhängigkeit der Verstärkung zu beseitigen. Die bekannte Schaltung erfordert wenigstens vier Anschlüsse, nämlich je zwei für die Versorgungsspannung und je zwei für das Ausgangssignal.

Mit der vorliegenden Erfindung soll die Aufgabe gelöst werden, eine Verstärkung und Signalformung mit möglichst geringem Aufwand an Bauteilen und möglichst wenig Zu-und Ableitungen zu erreichen.

Gelöst wird diese Aufgabe durch die im Kennzeichen des Anspruchs 1 angegebenen Merkmale. Durch die geringe Anzahl von kleinen Bauteilen können diese in ein einziges Gehäuse zusammengefaßt werden und es sind nur zwei Zuleitungen dazu notwendig. Weitere vorteilhafte Einzelheiten sind in den Unteransprüchen angegeben und anhand der in der Zeichnung veranschaulichten Ausführungsbeispiele beschrieben.

Es zeigen:

Fig. 1 eine Schaltung mit einem R-C-Glied,

Fig. 2 die Anordnung der magnetfeldabhängigen Widerstände relativ zu Zähnen eines Zahnrades oder einer Zahnstange,

Fig. 3 das Diagramm eines Meßsignals,

Fig. 4 das Diagramm eines geformten Ausgangssignals und

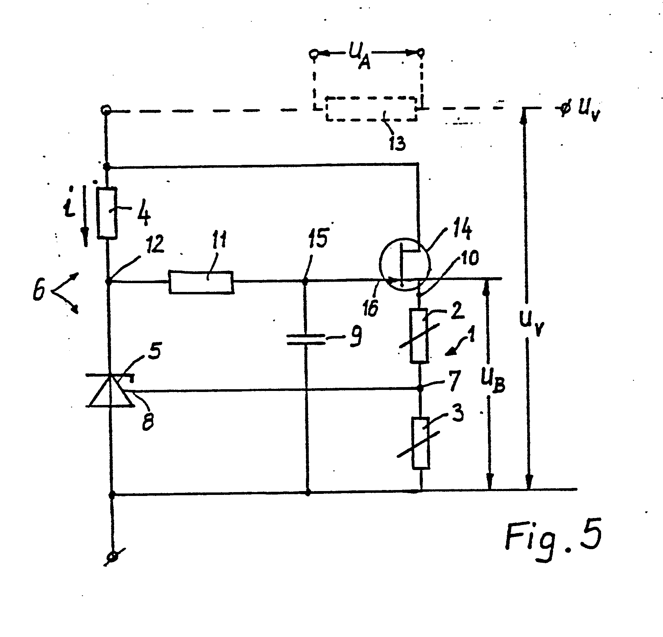

Fig. 5 eine Schaltung mit einem vom R-C-Glied angesteuerten Feldeffekttransistor.

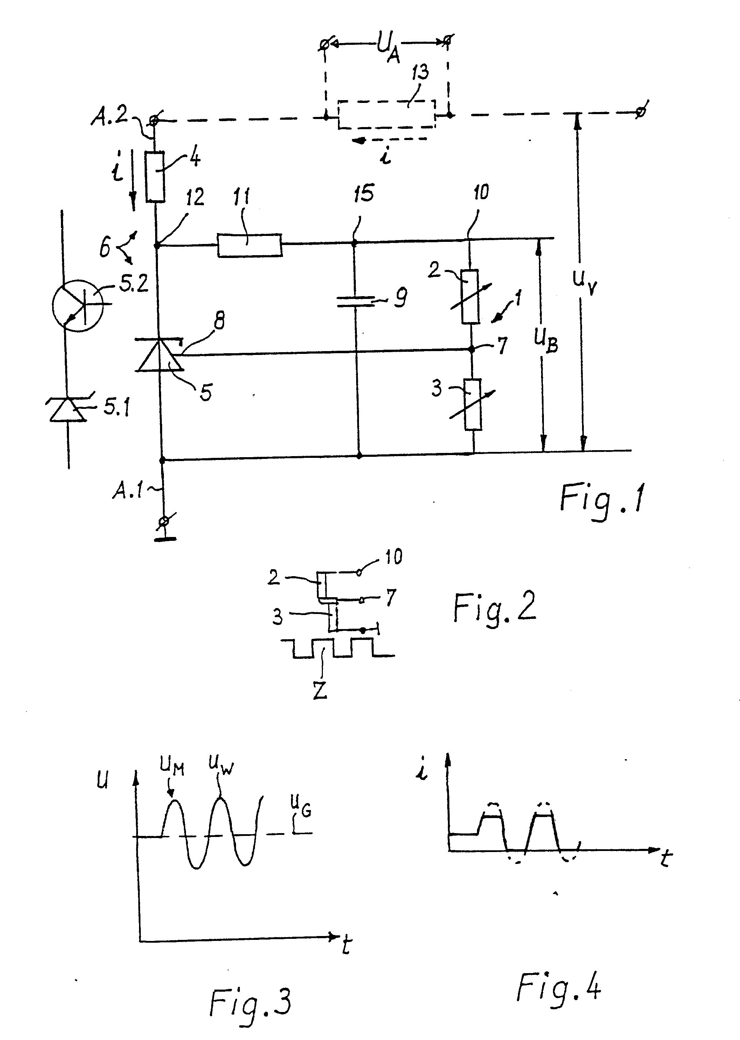

Mit 2 ist ein Spannungsteiler aus zwei magnetfeldabhängigen Widerständen 2 und 3 bezeichnet. Sie sind beispielsweise bei gleicher Zahnung um einen viertel Zahnabstand gegeneinander versetzt angeordnet, wie in der Skizze von Fig. 2 dargestellt. Der Spannungsteiler 1 kann auch nur einen einzigen magnetfeldabhängigen Widerstand und einen ohmschen Widerstand aufweisen. Der Spannungsteiler 1 erhält seine Betriebsspannung $U_B$ über einen Vorwiderstand 4 von einer Versorgungsspannung $U_V$.

Parallel zum Spannungsteiler 1 ist eine steuerbare Impedanz 5, insbesondere eine steuerbare Zenerdiode, z.B. der IC-Typ TL 431 oder, wie neben der Fig. 1 abgebildet, eine Reihenschaltung aus einer Zenerdiode 5.1 und einem Längstransistor 5.2, geschaltet, die mit dem Vorwiderstand 4 einen zweiten Spannungsteiler 6 bildet. Der Teilerpunkt 7 des ersten Spannungsteilers 1 ist mit dem Steuereingang 8 der steuerbaren Impedanz 5 verbunden. Zum ersten Spannungsteiler 1 liegt noch ein Kondensator 9 parallel und vom Hochpunkt 10 des Spannungsteilers 1 ist ein Widerstand 11 zum Teilerpunkt 12 des zweiten Spannungsteilers 6 geschaltet. Der Widerstand 11 bildet mit dem Kondensator 9 ein Zeitglied, dessen Zeitkonstante größer, insbesondere 5 bis 20mal größer ist als die niedrigste am Teilerpunkt 7 des Spannungsteilers 1 auftretende Frequenz des Wechselspannungsanteils $U_W$.

Die Wirkungsweise der Schaltung ist wie folgt:

Die beiden magnetfeldabhängigen Widerstände 2, 3 bewegen sich relativ zu einem ferromagnetischen Zahnrad oder einer Zahnstange Z etc., das bzw. die selbst magnetisiert sein kann. Bei nichtmagnetisiertem Zahnrad oder einer Zahnstange sind den magnetfeldabhängigen Widerständen in bekannter Weise ein Permanentmagnet zugeordnet, dessen Magnetfeld die magnetfeldabhängigen Widerstände durchsetzt und dessen Richtung in den magnetfeldabhängigen Widerständen durch das äußere ferromagnetische Teil verändert und damit deren Widerstand ebenfalls verändert wird. Beim Vorbeibewegen der Zähne des Zahnrades Z an den um einen viertel Zahnabstand gegeneinander versetzten magnetfeldabhängigen Widerständen 2, 3 erhöht sich z.B. der Widerstandswert des einen magnetfeldabhängigen Widerstandes 2 und erniedrigt sich derjenige des anderen magnetfeldabhängigen Widerstandes 3 und umgekehrt periodisch von einem gleichen Normwert aus. Hierdurch erhält man am Teilerpunkt 7 ein Meßsignal $U_M$, das aus einem mit einer Wechselspannung $U_W$ überlagerten Gleichspannungsanteil $U_G$ besteht. Das Meßsignal $U_M$ steuert die Impedanz 5 derart, daß bei sinkender Spannung am Teilerpunkt 7 die Spannung am Teilerpunkt 12 ansteigt. Ohne Kondensator 9 und Widerstand 11 würde dies eine Erhöhung der Betriebsspannung $U_B$ am ersten Spannungsteiler 1 bedingen, bis die Spannung am Teilerpunkt 7 der Referenzspannung des Steuereingangs der steuerbaren Impedanz 5 entspricht. Bei dem angegebenen Typ TL 431 sind dies 2,5 V.

Infolge der hohen Zeitkonstante des R-C-Gliedes 9, 11 wirkt sich die Impedanzänderung der Impedanz 5 nicht am ersten Spannungsteiler 1 aus, es findet also keine Regelung statt. Hierdurch wird durch die Impedanzänderung des zweiten Spannungsteilers 6 der durch ihn fließende Strom verändert und damit eine Verstärkung des Meßsignals $U_M$ erreicht. An einem in der Zuleitung zur Versorgungsspannung $U_V$ eingeschalteten, gestrichelt eingezeichneten Widerstand 13 kann dann eine entsprechende Ausgangsspannung $U_A$ zur weiteren Verarbeitung abgenommen werden. Dieser Widerstand kann irgendwo in der Zuleitung vorgesehen werden und es braucht daher keine Zu-und Ableitung zu der besprochenen Schaltung vorgenommen werden.

Wird die Spannung am Teilerpunkt 7 in nicht beeinflußtem Zustand der magnetfeldabhängigen Widerstände so gewählt, daß diese gleich der Referenzssteuerspannung der steuerbaren Impedanz 5 ist und das Wechselspannungssignal am Teilerpunkt 7 so groß ist, daß die steuerbare Impedanz 5 ganz durchgesteuert oder ganz gesperrt wird, so erhält man einen Strom im zweiten Spannungsteiler 6, der angenähert eine Rechteckspannung darstellt, in dem, wie in Fig. 4 dargestellt, die Spitzen des Wechselspannungsanteils $U_M$ keine Impedanzänderungen mehr verursachen können.

Bei Verwendung einer integrierten steuerbaren Impedanz des genannten Typs TL 431 werden Änderungen der Werte der Schaltung, z.B. Temperaturänderungen oder Alterungen und damit Widerstandsänderungen der magnetfeldabhängigen Widerstände 2 und 3 oder der weiteren Schaltungsbauteile, ausgeglichen, da dieser Schaltkreis eine interne Temperaturkompensation enthält. Das erreichbare Ausgangssignal $U_A$ ist daher sehr stabil. Außerdem sind zur Funktion der Schaltung lediglich zwei Anschlußleitungen erforderlich.

Bei der beschriebenen Schaltung sind zur Realisierung einer großen Zeitkonstante nur die Verwendung relativ niedriger Widerstandswerte für den Widerstand 11 möglich und daher hohe Kapazitätswerte für den Kondensator 9 erforderlich. Besonders letztere bedingen große Kondensatorabmessungen. Um mit kleinen Abmessungen und damit kleinen Kapazitätswerten auszukommen, ist gemäß einer vorteilhaften Weiterbildung der Erfindung vom Hochpunkt 10 des ersten Spannungsteilers 1 zum Hochpunkt des Vorwiderstandes 4 die Drain-Source-Strecke eines Feldeffekttransistors 14 geschaltet und der Verbindungspunkt 15 des Kondensators 9 mit dem Widerstand 11 ist an die Steuerelektrode 16 angeschlossen und damit über die Steuerstrecke des Feldeffekttransistors 14 mit dem Hochpunkt 10 verbunden. Der Feldeffekttransistor 14 wirkt als Impedanzwandler und hält den Hochpunkt 10 auf konstantem Potential. Durch den sehr hohen Eingangswiderstand des Feldeffekttransistors 14 fließen in der Steuerstrecke nur ganz geringe Ströme, beispielsweise in der Größe von einigen Pikoampère. Dadurch kann der Kondensator 9 sehr klein gemacht werden. Bei einem Ausführungsbeispiel lag der Widerstandswert des Widerstandes 11 beispielsweise in der Größenordnung von etwa 10 MOhm bis zu einigen 10 MOhm und der Kapazitätswert des Kondensators 9 lag in der Größenordnung von 100 nF.

Von besonderem Vorteil ist der Aufbau der Schaltung mit wenigen kleinen Bauteilen, so daß die Schaltung zusammen mit dem ersten Spannungsteiler in einer baulichen Einheit zusammengefaßt und in einem gemeinsamen Gehäuse vorgesehen und mit zwei Leitungen versehen werden kann. Hierdurch kann diese Einheit leicht an beliebigen Stellen angebracht werden.

## Ansprüche

1. Schaltung zur Verstärkung eines am Teilerpunkt eines wenigstens einen magnetfeldabhängigen Widerstand aufweisenden Spannungssteilers, der über einen Vorwiderstand an eine Versorgungsspannung angeschlossen ist, abgegriffenen Meßsignals mit einem Wechselspannungsanteil und zur Formung desselben in ein zumindest einer Rechteckform angenähertes Ausgangssignal, **dadurch gekennzeichnet**, daß der von der Versorgungsspannung ($U_V$) gelieferte Strom (i) entsprechend der Änderung des Wechselspannungsanteils ($U_W$) des Meßsignals ($U_M$) durch einen in die Zuleitung der Versorgungsspannung ($U_V$) eingeschalteten und vom Meßsignal ($U_M$) angesteuerten steuerbaren Impedanzwandler (5) verändert wird.

2. Schaltung nach Anspruch 1, dadurch gekennzeichnet, daß parallel zum Spannungsteiler (1) eine steuerbare Impedanz (5) angeschlossen ist, die mit dem Vorwiderstand (4) einen zweiten Spannungsteiler (6) bildet und deren Steuerelektrode (8) mit dem Teilerpunkt (7) des Spannungssteilers (1) verbunden ist, daß außerdem parallel zu dem ersten Spannungsteiler (1) ein Kondensator (9) angeschlossen ist und zwischen dem Teilerpunkt (12) des zweiten Spannungsteilers (6) und dem an Betriebsspannung ($U_B$) liegenden Verbindungspunkt (15) von Kondensator (9) und erstem Spannungsteiler (1) ein Widerstand (11) eingeschaltet ist, der zusammen mit dem Kondensator (9) ein R-C-Glied bildet, dessen Zeitkonstante größer ist als die Periodendauer der am ersten Spannungsteiler (1) auftretenden niedrigsten Frequenz des Wechselspannungsanteils ($U_W$) des Meßsignals ($U_M$).

3. Schaltung nach Anspruch 1 oder 2, dadurch gekennzeichnet, daß die steuerbare Impedanz eine steuerbare Zenerdiode (5) ist.

4. Schaltung nach Anspruch 2 oder 3, dadurch gekennzeichnet, daß die Zeitkonstante wenigstens achtmal so groß ist wie die kleinste auftretende Periodendauer des Wechselspannungsanteils ($U_W$).

5. Schaltung nach einem der Ansprüche 2 bis 4, dadurch gekennzeichnet, daß zwischen dem Hochpunkt (10) des ersten Spannungsteilers (1) und dem Hochpunkt des Vorwiderstandes (4) die Drain-Source-Strecke eines Feldeffekttransistors (14) angeschlossen ist und der Verbindungspunkt (15) des Kondensators (9) und des Widerstandes (11) mit der Steuerelektrode (16) des Feldeffekttransistors (14) verbunden ist.

6. Schaltung nach einem der Ansprüche 1 bis 5, dadurch gekennzeichnet, daß sie als bauliche Einheit in einem gemeinsamen Gehäuse vorgesehen ist und dieses mit zwei Anschlüssen versehen ist.

Fig.1

Fig.2

Fig.3

Fig.4

Fig.5